# EUROPÄISCHE PATENTANMELDUNG

(11) **EP 2 101 344 A1**
(43) Veröffentlichungstag der Anmeldung: **16.09.2009**
(21) Anmeldenummer: 09158192.6
(22) Anmeldetag: 22.12.2006
(51) Int. Cl.: H01J 61/54, H01J 61/56, H05B 31/00, H03K 3/537, H01G 4/12, H01P 11/00, H01J 61/34, H01F 27/32, H01F 41/06

(54) **Hochspannungspulsgenerator und Hochdruckentladungslampe mit derartigem Hochspannungspulsgenerator**

(30) Priorität: 23.12.2005 DE 102005061832
(62) Teilanmeldung aus: 06848650.5
(71) Anmelder: Osram Gesellschaft mit beschränkter Haftung, 81543 München (DE)
(72) Erfinder: Liepold, Ute, 80939 München (DE); Kloss, Andreas, 85579 Neubiberg (DE); Schuh, Carsten, 85598 Baldham (DE); Steinkopff, Thorsten, 85658 Egmating (DE); Stockwald, Klaus, 82110 Germering (DE); Walter, Steffen, 85667 Oberpframmern (DE)

(57) **Zusammenfassung**

Ein kompakter Spiral-Puls-Generator ist als LTCC-Bauteil oder HTCC-Bauteil aus Keramikfolien und darauf angebrachter Metallisierung in Form von metallischer Leitpaste oder metallischer Folie ausgeführt.

## Beschreibung

### Technisches Gebiet

Die Erfindung betrifft einen Hochspannungspulsgenerator, der insbesondere für eine Lampe eingesetzt werden kann.

### Stand der Technik

Das Problem der Zündung von Hochdruckentladungslampen wird derzeit dadurch gelöst, dass das Zündgerät in das Vorschaltgerät integriert ist. Nachteilig daran ist, dass die Zuleitungen hochspannungsfest ausgelegt sein müssen.

In der Vergangenheit hat es immer wieder Versuche gegeben, die Zündeinheit in die Lampe zu integrieren. Dabei wurde versucht, sie in den Sockel zu integrieren. Eine besonders effektive und hohe Pulse versprechende Zündung gelingt mittels sog. Spiral-Puls-Generatoren, siehe US-A 3 289 015. Vor längerer Zeit wurden derartige Geräte bei verschiedenen Hochdruckentladungslampen wie Metallhalogenidlampen oder Natriumhochdrucklampen vorgeschlagen, siehe beispielsweise US-A 4 325 004, US-A 4 353 012. Sie konnten sich jedoch nicht durchsetzen, weil sie zum einen zu teuer sind. Zum andern ist der Vorteil, sie in den Sockel einzubauen, nicht ausreichend, da das Problem des Zuführens der Hochspannung in den Kolben bleibt. Daher die Wahrscheinlichkeit für Schädigungen der Lampe, seien es Isolationsprobleme oder ein Durchbruch im Sockel, steigt stark an. Bisher übliche Zündgeräte konnten Im allgemeinen nicht über 100 °C erwärmt werden. Die erzeugte Spannung musste dann der Lampe zugeführt werden, was Leitungen und Lampenfassungen mit entsprechender

Hochspannungsfestigkeit erfordert, typisch etwa 5 kV.

### Darstellung der Erfindung

Die Aufgabe der vorliegenden Erfindung ist es, einen kompakten Hochspannungspulsgenerator anzugeben

Diese Aufgabe wird gelöst durch die kennzeichnenden Merkmale des Anspruchs 1.

Besonders vorteilhafte Ausgestaltungen finden sich in den abhängigen Ansprüchen.

Erfindungsgemäß wird jetzt ein Hochspannungspuls mit minbestens 1,5 kV, der zur Zündung der Lampe notwendig ist, mittels eines speziellen temperaturresistenten Spiral-Puls-Generators erzeugt, der **insbesondere** in unmittelbarer Nähe des Entladungsgefäßes im Außenkolben integriert wird. Nicht nur eine Kaltzündung sondern auch ein Heißwiederzündung ist damit möglich.

Der jetzt verwendet Spiral-Puls-Generator ist insbesondere ein sog. LTCC-Bauteil. Damit ist gemeint, dass es aus LTCC-fähiger (Low Temperature Co-fired Ceramics) Keramik hergestellt ist. Dieses Material beschreibt eine spezielle Keramik, die bis 600 °C temperaturfest gemacht werden kann. Zwar wurde LTCC schon in Zusammenhang mit Lampen verwendet, siehe US 2003/0001519 und US-B 6 853 151. Jedoch wurde es für ganz andere Zwecke bei praktisch kaum temperaturbelasteten Lampen, mit typischen Temperaturen unter 100 °C, eingesetzt. Der besondere Wert der hohen Temperaturstabilität von LTCC in Zusammenhang mit der Zündung von Hochdruckentladungslampen, wie vor allem Metallhalogenidlampen mit Zündproblemen, ist im Stand der Technik nicht zu erkennen.

Der Spiral-Puls-Generator ist ein Bauteil, das Eigenschaften eines Kondensators mit denen eines Wellenleiters zur Erzeugung von Zündpulsen mit einer Spannung von mindestens 1,5 kV vereint, Für die Herstellung werden zwei keramische "Grün-Folien" mit metallischer Leitpaste bedruckt und anschließend versetzt zu einer Spirale augewickelt und schließlich isostatisch zu einem Formkörper gepresst. Die folgende Co-Sinterung von Metallpaste und keramischer Folie erfolgt an Luft im Temperaturbereich zwischen 800 und 1100°C, insbesondere im Bereich 800 bis 900°C. Diese Verarbeitung erlaubt einen Einsatzbereich des Spiral-Puls-Generators bis typisch 700°C Temperaturbelastung. Dadurch kann der Spiral-Puls-Generator in direkter Nähe des Entladungsgefäßes im Außenkolben, aber auch im Sockel oder in unmittelbarer Nähe der Lampe untergebracht werden.

Für die Herstellung von Spiral-Puls-Generatoren können aber auch keramische "Grünfolien" mit metallischer Leitpaste verwendet werden, die zum Bereich der Sintertemperaturen von HTCC-Materialien (High Temperatur Co-fired Ceramics) gehören. Dies sind beispielsweise: Al₂O₃, ZrO₂ etc.. Diese Materialklasse wird im Hochtemperaturbereich zwischen 1100 und 1800°C dicht gesintert.

Die Sinterung kann auch in Stickstoff (N2), Argon (Ar), oder Wasserstoff (H2) oder Gemischen davon, mit unterschiedlichen Gaszusammensetzungen und Mischungsverhältnissen, erfolgen.

Für die Herstellung des Spiral-Puls-Generators können bevorzugt keramische Grünfolien verwendet werden, die nach der Sinterung eine relative Dielektrizitätskonstante (D.K.) epsilon (ε) von 5 bis 20000 aufweisen. Das ermöglicht eine sehr hohe Kapazität des Spiralkondensators, und außerdem eine vergleichsweise große Breite des erzeugten Hochspannungs-Impulses. Praktisch gute Werte für D.K. liegen bei ε = 10 bis 100.

Somit wird eine sehr kompakte Bauweise möglich, was den Einbau des Spiral-Puls-Generators direkt in den Außenkolben einer Lampe oder in deren Sockel ermöglicht. Die hohe Pulsbreite begünstigt außerdem den Durchschlag im Plasma des Entladungsgefäßes.

Als Metallisierung auf der Folie eignen sich vorzugweise alle Pastensysteme, die mindestens eine metallische Komponente haben und die nach dem Sinterprozess elektrische Strom leiten. Dies sind vorzugsweise:
Arg, Cu, Mo, Ni, Pt, Mischungen aus Ag und Pd gemäß der Zusammensetzung AgₓPd₁₋ₓ. Dabei ist x bevorzugt im Bereich 0,5 bis 0,99.

Die Metallisierung kann auch in Form von metallischen Folien auf die keramischen Substrate laminiert werden. Die Dicke der Folien liegt bevorzugt im Bereich 1 bis 100 µm. Dabei kann die Folie vor oder während des formgebenden Wickelprozesses aufgebracht werden.

Ein nichtmetallisches geeignetes Stoffsystem für eine leitfähige Beschichtung ist Graphit.

Ein nichtmetallisch-anorganisches Stoffsystem für eine leitfähige Beschichtung sind elektrisch leitfähige Keramiken oder Cermets.

Für die Herstellung von Spiral-Puls-Generatoren eignen sich grundsätzlich bevorzugt alle keramischen Stoffsysteme, aus denen über einen Schlicker keramische Grünfolien gezogen werden können. Die keramischen Stoffsystem (nichtmetallisch-anorganisch) besitzen im Grundzustand eine D.K. zwischen Er = 5 und εᵣ = 20000. Geeignet sind aber auch Stoffsysteme und Mischungen, in denen mindestens eine Komponente ein keramisches Stoffsystem darstellt. Dies sind insbesondere die Stoffe aus Tab. 1.

**Tab. 1**

| Material | D.K. εᵣ (ca.) |
|---|---|
| Keramische Substrate der LTCC-Technologie | 3 bis 10 000 |
| Übliche Materialien der Kondensatorfertigung | 10 bis 20 000 |
| Materialien aus der Gruppe Bariumtitanate sowie Ba-Sr-Titanate | 500 bis 12000, insb. 3000 bis 7000 |
| Materialien aus der Gruppe Barium-Zirkonat-Titanate | 15 000 bis 21 000 |
| Materialien aus der Gruppe Blei-Zirkonat-Titanate, sog. PZT, insb. harte und weiche PZT | 1 500 bis 2 500 |
| PZT mit Additiven | 8 000 bis 9 500 |
| Materialien aus der Gruppe Blei-Magnesium-Niobate, sog. PMN | 18 000 bis 20 000 |
| Materialien aus der Gruppe Blei-Zink-Niobate, sog. PZN | 17 000 bis 20 500 |
| Materialien aus der Gruppe Kalium-Natrium-Niobate, sog. KNN | 700 bis 1200 |
| Materialien aus der Gruppe Wismut-basierter Perowskite | 800 bis 1150 |
| Materialien aus der Gruppe Wolfram-Bronzen | 800 bis 1200 |

Die Vorteile einer derartigen Materialwahl sind:
- hohe Einsatztemperatur, so dass der Spiral-Puls-Generator in unmittelbarer Nähe der Lampe, in deren Sockel oder sogar in deren Außenkolben eingebaut werden kann;
- kleine Bauform;
- hochspannungsfeste Zuleitungen können entfallen;
- hohe Energiespeicherfähigkeit und daraus folgend hohe Zündpulsenergie;
- die Pulsbreite zum Starten einer Hochdruckentladungslampe kann in Abhängigkeit von der D.K. erhöht werden; typische resultierende Pulsbreiten sind 50 bis 200 ns.
- die Ladespannung kann in Abhängigkeit von der Wicklungszahl um den Faktor 5 bis 200 erhöht werden.

Ein konkreter Spiralpulsgenerator ist beispielsweise aus keramischem LTCC-Material gefertigt mit einem ε von 65. Die Tapelänge ist 50 cm bis 110 cm. Die Metallisierung ist eine Leitpaste aus Ag. Der resultierende Spiral-Puls-Generator hat beispielsweise einen Außendurchmesser von etwa 1,4 cm bis 2,5 cm.

Unabhängig davon kann ein derartiger Spiral-Puls-Generator auch für andere Anwendungen eingesetzt werden, weil er nicht nur hochtemperaturstabil ist, sondern auch äußerst kompakt . Dafür ist wesentlich, dass der Spiral-Puls-Generator als LTCC-Bauteil ausgeführt ist, bestehend aus Keramikfolien und metallischer Leitpaste. Um ausreichend Ausgangspannung zu liefern, sollte die Spirale mindestens 5 Windungen umfassen.

Zudem lässt sich auf Basis dieses Hochspannungspulsgenerators eine Zündeinheit angeben, die weiterhin zumindest einen Ladewiderstand und einen Schalter umfasst. Der Schalter kann eine Funkenstrecke oder auch ein Diac in SiC-Technologie sein.

Bevorzugt ist im Falle einer Anwendung für Lampen die Unterbringung im Außenkolben. Denn dadurch entfällt die Notwendigkeit einer hochspannungsfesten Spannungszuleitung.

Zudem lässt sich ein Spiral-Puls-Generator so dimensionieren, dass der Hochspannungspuls sogar eine Heißwiederzündung der Lampe ermöglicht. Das Dielektrikum aus Keramik zeichnet sich durch eine außergewöhnlich hohe Dielektrizitätskonstante εᵣ im Bereich von εᵣ > 10 aus, wobei je nach Material und Bauweise ein ε von typisch ε = 70 bis 100 erreicht werden kann. Das schafft eine sehr hohe Kapazität des Spiral-Puls-Generators und ermöglicht eine vergleichsweise große zeitliche Breite der erzeugten Impulse. Dadurch wird eine sehr kompakte Bauweise des Spiral-Puls-Generators möglich, so dass ein Einbau in handelsübliche Außenkolben von Hochdruckentladungslampen gelingt.

Die große Pulsbreite erleichtert zudem den Durchschlag im Entladungsvolumen.

Als Material des Außenkolbens kann jedes übliche Glas verwendet werden, also insbesondere Hartglas, Vycor oder Quarzglas. Auch die Wahl der Füllung unterliegt keiner besonderen Einschränkung.

### Kurze Beschreibung der Zeichnungen

Im Folgenden soll die Erfindung anhand mehrerer Ausführungsbeispiele näher erläutert werden. Die Figuren zeigen:
- Fig. 1: den prinzipiellen Aufbau eines Spiral-Puls-Generators;
- Fig. 2: Kenngrößen eines LTCC- Spiral-Puls-Generators;
- Fig. 3: den Prinzipaufbau einer Hochdruckentladungslampe mit dritter Zünd-Elektrode mit einem Spiral-Puls-Generator im Außenkolben.
- Fig. 4: den Prinzipaufbau einer Hochdruckentladungslampe mit Überlagerungszündung, mit spiral-Puls-Generator im Außenkolben.
- Fig. 5: eine Metallhalogenidlampe mit Spiral-Puls-Generator im Außenkolben;
- Fig. 6: eine Metallhalogenidlampe mit Spiral-Puls-Generator im Sockel.
- Fig. 7: einen Spiral-Puls-Generator mit eingebauter Funkenstrecke;
- Fig. 8: eine Messung der resultierenden Ausgangsspannung als Funktion der Zeit für einen typischen Spiral-Puls-Generator. Bevorzugte Ausführungsform der Erfindung

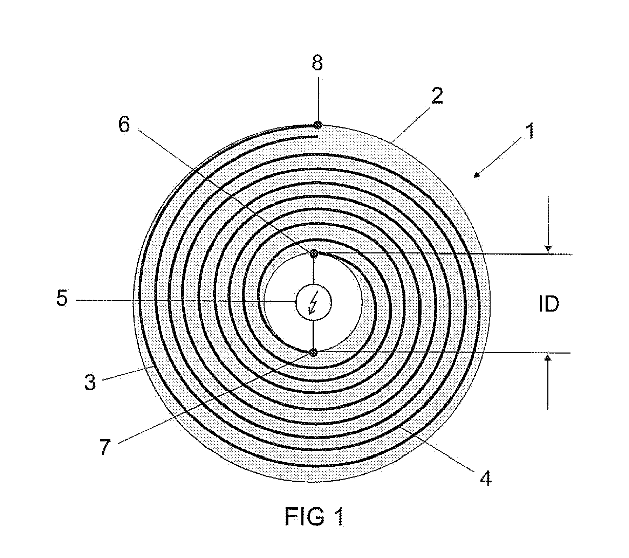

Figur 1 zeigt den Aufbau eines Spiral-Puls-Generators 1 in Draufsicht. Er besteht aus einem keramischen Zylinder 2, in den zwei verschiedene metallische Leiter 3 und 4 spiralförmig eingewickelt sind. Der Zylinder 2 ist innen hohl und besitzt einen gegebenen Innendurchmesser ID. Die beiden inneren Kontakte 6 und 7 der beiden Leiter 3 und 4 liegen benachbart und sind über eine Funkenstrecke 5 miteinander verbunden.

Nur der äußere der beiden Leiter besitzt am äußeren Rand des Zylinders einen weiteren Kontakt 8. Der andere Leiter endet offen. Die beiden Leiter bilden zusammen einen Wellenleiter mit einem offenen Ende, wobei der Wellenleiter in einem dielektrischen Medium, der Keramik, realisiert ist.

Der Spiral-Puls-Generator wird entweder aus zwei mit Metallpaste beschichteten keramischen Folien gewickelt oder aus zwei Metallfolien und zwei keramischen Grünfolien aufgebaut. Eine wichtige Kenngröße ist dabei die Zahl n der Windungen, die bevorzugt in der Größenordnung 5 bis 100 liegen soll. Diese Wickelanordnung wird laminiert und anschließend co-gesintert, wodurch ein keramisches Bauteil, insbesondere ein LTCC-Bauteil, entsteht. Die so geschaffenen Spiral-Puls-Generatoren mit Kondensatoreigenschaft werden dann mit einer Funkenstrecke sowie einem Ladewiderstand beschaltet.

Die Funkenstrecke kann sich an den inneren oder den äußeren Anschlüssen oder auch innerhalb der Wicklung des Generators befinden. Als Hochspannungsschalter, der den Puls initiiert, kann bevorzugt eine Funkenstrecke verwendet werden. Weiterhin ist die Verwendung eines hochtemperaturfesten Halbleiterschalters, bevorzugt in SiC-Technologie, möglich. Beispielsweise kann das Schaltelement MESFET der Fa. Cree verwendet werden. Dieses ist für Temperaturen bis 350°C geeignet.

In einem konkreten Ausführungsbeispiel wird ein Keramikmaterial mit ε = 60 bis 70 verwendet. Dabei wird bevorzugt als Dielektrikum eine Keramikfolie, insbesondere ein Keramikband wie Heratape CT 700 oder CT 707 oder bevorzugt CT 765, jeweils von Heraus, oder auch eine Mischung von mindestens zweien davon verwendet. Die Dicke der grünen Folie beträgt typisch 50 bis 150 µm. Als Leiter wird insbesondere Ag-Leitpaste wie "Cofirable Silver," ebenfalls von Heraus, verwendet. Ein konkretes Beispiel ist TC 7303 von Heraeus. Gute Ergebnisse liefert auch die Metallpaste 6142 von DuPont. Diese Teile lassen sich gut laminieren und danach ausheizen ("binder burnout") und zusammen sintern ("co-firing").

Der Innendurchmesser ID des konkreten Spiral-Puls-Generator ist 10-14 mm. Die Breite der einzelnen Streifen ist etwa 6 bis 9 mm. Die Foliendicke ist 50-80 µm und die Dicke der beiden Leiter ist jeweils 7 bis 12 µm. Bei einer Ladespannung von 300 V generiert dieser Generator 2500 V. Unter diesen Voraussetzungen erreicht der Spiral-Puls-Generator ein Optimum seiner Eigenschaften bei einer Windungszahl von etwa n = 19.

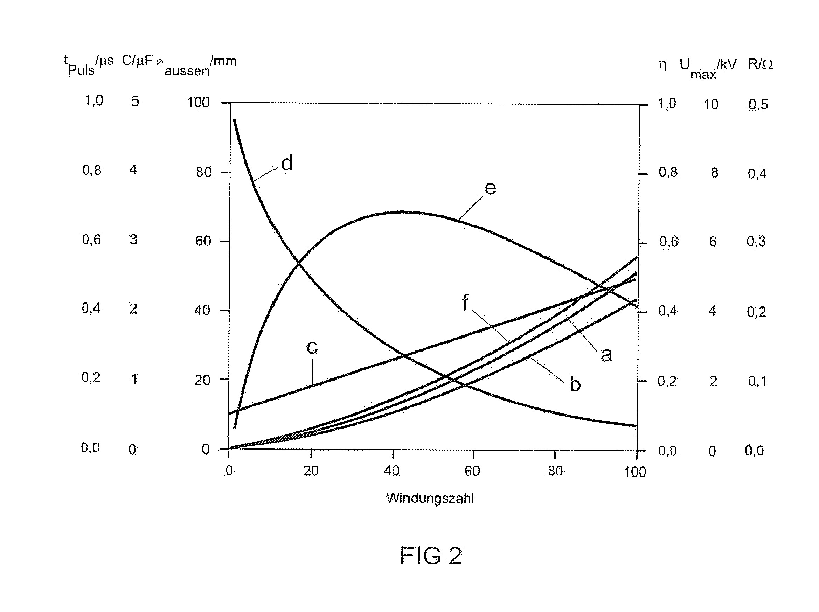

In Figur 2 sind die zugehörige Halbwertsbreite des Hochspannungspulses in µs (Kurve a), die Gesamtkapazität des Bauteils in µF (Kurve b), der resultierende Außendurchmesser in mm (Kurve c), sowie die Effizienz (Kurve d), die maximale Pulsspannung (Kurve e) in kV und der Leiterwiderstand in Ω (Kurve f) dargestellt.

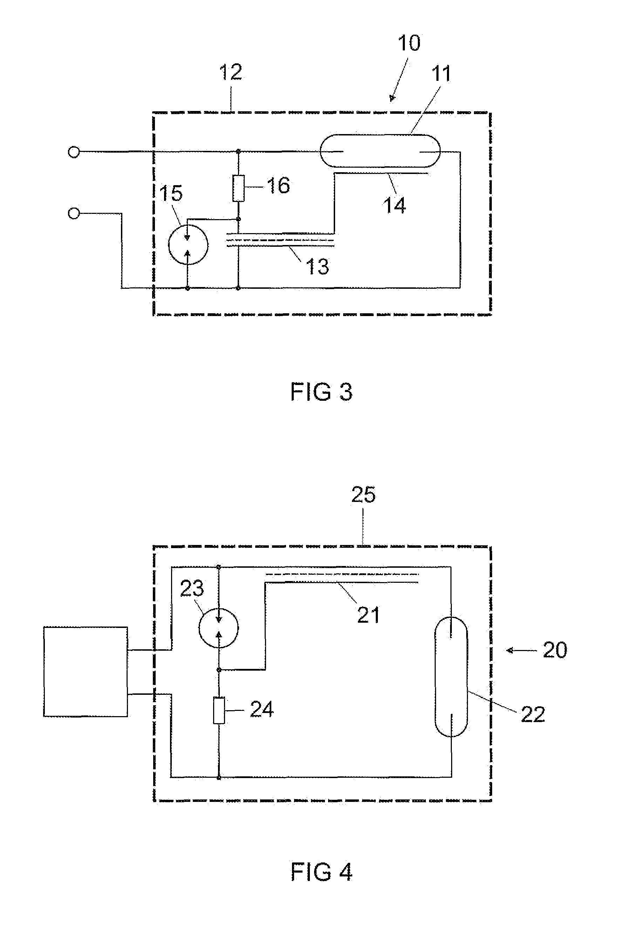

Figur 3 zeigt den prinzipiellen Aufbau einer Hochdruckentladungslampe, insbesondere einer Natriumhochdrucklampe 10, mit keramischem Entladungsgefäß 11 und Außenkolben 12 mit darin integriertem Spiral-Puls-Generator 13, wobei eine Zünd-Elektrode 14 außen am keramischen Entladungsgefäß 11 angebracht ist. Der Spiral-Puls-Generator 13 ist mit der Funkenstrecke 15 und dem Ladewiderstand 16 im Außenkolben untergebracht.

Figur 4 zeigt den prinzipiellen Aufbau einer Hochdruckentladungslampe, insbesondere einer Metallhalogenidlampe 20, mit integriertem Spiral-Puls-Generator 21, wobei keine Zünd-Elektrode außen am Entladungsgefäß 22, das aus Quarzglas oder Keramik gefertigt sein kann, angebracht ist. Der Spiral-Puls-Generator 21 ist mit der Funkenstrecke 23 und dem Ladewiderstand 24 im Außenkolben 25 untergebracht. Der Hochspannungspuls wird der Betriebsspannung der Lampe überlagert und über eine Hauptelektrode zugeführt.

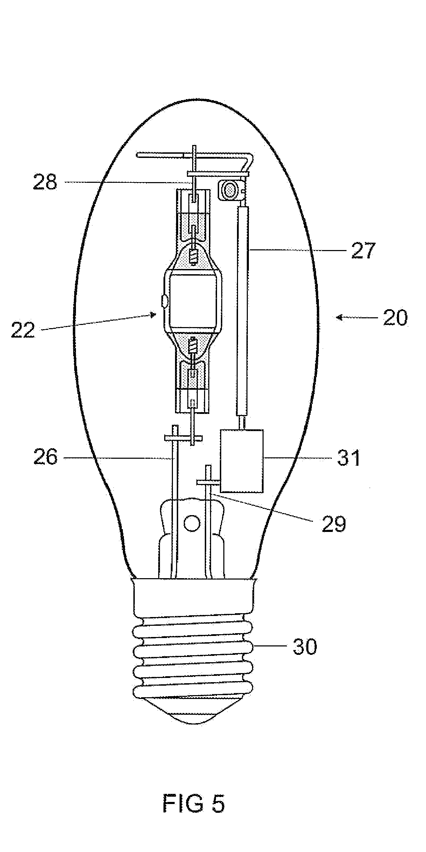

Figur 5 zeigt eine Metallhalogenidlampe 20 mit einem Entladungsgefäß 22, das von zwei Zuleitungen 26, 27 in einem Außenkolben gehaltert wird. Die erste Zuleitung 26 ist ein kurz abgewinkelter Draht. Die zweite 27 ist im wesentlichen ein Stab, der zur sockel fernen Durchführung 28 führt. Zwischen der Zuleitung 29 aus dem Sockel 30 und dem Stab 27 ist eine Zündeinheit 31 angeordnet, die den Spiral-Puls-Generator, die Funkenstrecke und den Ladewiderstand enthält, wie in Figur 4 angedeutet.

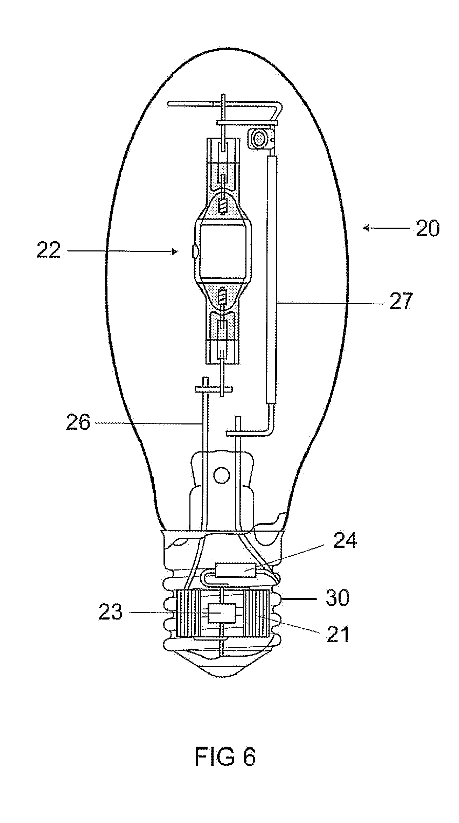

Figur 6 zeigt eine Metallhalogenidlampe 20 ähnlich wie Figur 5 mit einem Entladungsgefäß 22, das von zwei Zuleitungen 26, 27 in einem Außenkolben 25 gehaltert wird. Die erste Zuleitung 26 ist ein kurz abgewinkelter Draht. Die zweite 27 ist im wesentlichen ein Stab, der zur sockelfernen Durchführung 28 führt. Hier ist die Zündeinheit im Sockel 30 angeordnet, und zwar sowohl der Spiral-Puls-Generator 21, als auch die Funkenstrecke 23 und der Ladewiderstand 24.

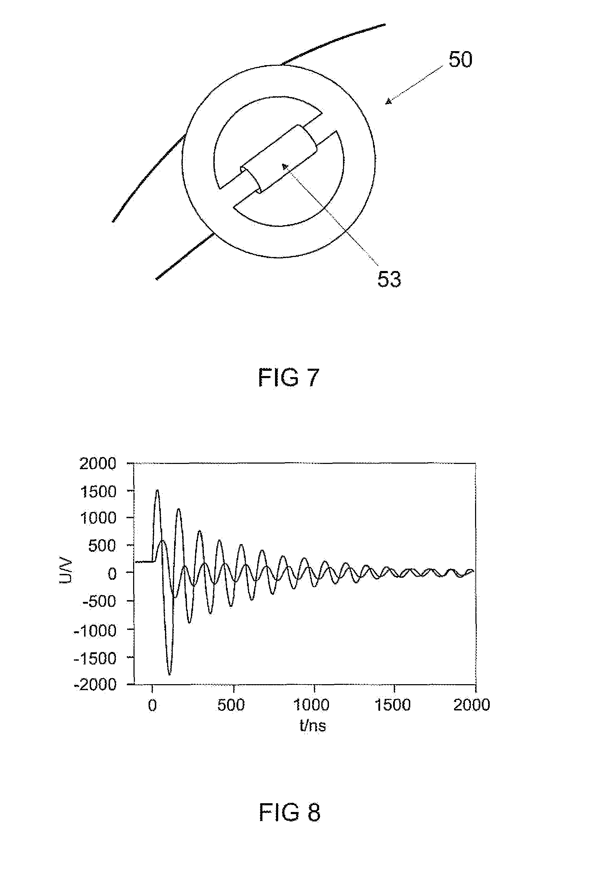

Figur 7 zeigt die körperliche Realisierung eines Spiral-Puls-Generators 50 mit eingebauter Funkenstrecke 53. Er besitzt zwei elektrische Anschlüsse im Inneren an oder Funkenstrecke 53 und einen Anschluss am äußeren Umfang.

Figur 8 zeigt die Messung der Ausgangsspannung Uₒᵤₜ an einem keramischen Spiralpulsgenerator mit 230 V Eingangsspannung im Kurzschluss. Die Ausgangsspannung Dₒᵤₜ ist als Funktion der Zeit t (in ns) dargestellt. Die maximale Ausgangsspannung ist hier beispielhaft -1850 V.

Diese Technik kann auch für elektrodenlose Lampen gangewendet werden, wobei der Spiral-Puls-Generator als Zündhilfe dienen kann.

Weitere Anwendungen dieses kompakten Hochspannungspulsgenerators liegen in der Zündung anderer Geräte. Die Anwendung ist vor allem bei sog. maischen Kugeln, bei der Erzeugung von Röntgenpulsen und der Erzeugung von Elektronenstrahl-Pulsen vorteilhaft. Auch ein Einsatz in Kfz als Ersatz für die üblichen Zündspulen ist möglich.

Dabei werden Windungszahlen von n bis 500 verwendet, so dass die Ausgangsspannung bis in die Größenordnung von 100 kV erreicht. Denn die Ausgangsspannung U_{A} ist als Funktion der Ladespannung U_{L} gegeben durch U_{A} = 2 x n x U_{L} x η, wobei die Effizienz η durch η = (AD-ID)/AD gegeben ist.

Die Erfindung entfaltet besondere Vorteile im Zusammenwirken mit Hochdruckentladungslampen, für Autoscheinwerfer, die mit Xenon unter hohem Druck von bevorzugt mindestens 3 bar und Metallhalogeniden gefüllt sind. Diese sind besonders schwer zu zünden, da wegen des hohen Xenondrucks die Zündspannung mehr als 10 kV beträgt. Derzeit wird versucht, die Komponenten der Zündeinheit im Sockel unterzubringen. Ein Spiral-Puls-Generator mit integriertem Ladewiderstand kann entweder in den Sockel der Kfz-Lampe oder in einen Außenkolben der Lampe untergebracht sein.

Die Erfindung entfaltet ganz besondere Vorteile im Zusammenwirken mit Hochdruckentladungslampen, die kein Quecksilber enthalten. Derartige Lampen sind aus Umweltschutzgründen besonders erstrebenswert. Sie enthalten eine geeignete Metallhalogenid-Füllung und insbesondere ein Edelgas wie Xenon unter hohem Druck. Wegen des fehlenden Quecksilbers ist die Zündspannung besonders hoch. Sie beträgt typisch mindestens 5 kV, kann aber auch mehr als 20 kV betragen. Derzeit wird versucht, die Komponenten der Zündeinheit im Sockel unterzubringen. Ein Spiral-Puls-Generator mit integriertem Ladewiderstand kann entweder in den Sockel der Quecksilberfreien Lampe oder in einen Außenkolben der Lampe untergebracht sein.

## Patentansprüche

1. Kompakter Hochspannungspulsgenerator auf der Basis eines Spiral-Puls-Generators, **dadurch gekennzeichnet, dass** der Spiral-Puls-Generator als LTCC-Bauteil oder HTCC-Bauteil aus Keramikfolien und darauf angebrachter Metallisierung in Form von metallischer Leitpaste oder metallischer Folie ausgeführt ist.

2. Hochspannungspulsgenerator nach Anspruch 1, **dadurch gekennzeichnet, dass** die Spirale mindestens n = 5 Windungen und bevorzugt höchstens n = 500 Windungen umfasst.

3. Hochspannungspulsgenerator nach Anspruch 1, **dadurch gekennzeichnet, dass** die Keramikfolie mindestens ein Material aus der Gruppe der Titanate oder Niobate, der Wismut-basierten Perowskite oder der Wolfram-Bronzen verwendet.

4. Hochspannungspulsgenerator nach Anspruch 1, **dadurch gekennzeichnet, dass** die Dielektrizitätskonstante des Materials zwischen 3 und 21 000, bevorzugt zwischen 5 und 20 000, gewählt ist.

5. Hochdruckentladungslampe mit einem Entladungsgefäß und mit einer zugeordneten Zündvorrichtung, wobei die Zündvorrichtung Hochspannungspulse erzeugt und einen Spiral-Puls-Generator enthält, gemäß einem der vorhergehenden Ansprüche.

6. Hochdruckentladungslampe nach Anspruch 5, **dadurch gekennzeichnet, dass** der Spiral-Puls-Generator in einem Außenkolben der Lampe untergebracht ist.

7. Hochdruckentladungslampe nach Anspruch 5, **dadurch gekennzeichnet, dass** die gesamte Zündvorrichtung im Außenkolben untergebracht ist.

8. Hochdruckentladungslampe nach Anspruch 5, **dadurch gekennzeichnet, dass** der Spiral-Puls-Generator aus mehreren Schichten aufgebaut ist, wobei die Anzahl n der Schichten mindestens n = 5 beträgt.

9. Hochdruckentladungslampe nach Anspruch 8, **dadurch gekennzeichnet, dass** die Anzahl n der Schichten höchstens n = 500, bevorzugt höchstens n = 100, beträgt.

10. Hochdruckentladungslampe nach Anspruch 5, **dadurch gekennzeichnet, dass** der Spiral-Puls-Generator in etwa hohlzylindrische Gestalt hat, mit einem Innendurchmesser von mindestens 10 mm.

11. Hochdruckentladungslampe nach Anspruch 5, **dadurch gekennzeichnet, dass** die Dielektrizitätskonstänte εᵣ des Spiral-Puls-Generators bei mindestens εᵣ = 10 liegt.

12. Hochdruckentladungslampe nach Anspruch 5, **dadurch gekennzeichnet, dass** im Außenkolben außerdem ein Vorwiderstand untergebracht ist, der den Ladestrom des Spiral-Puls-Generators begrenzt.

13. Zündeinheit auf Basis eines Hochspannungspulsgenerators nach einem der vorhergehenden Ansprüche 1 bis 4, **dadurch gekennzeichnet, dass** sie weiterhin zumindest einen Ladewiderstand und einen Schalter umfasst.
